(19) Europäisches Patentamt
European Patent Office
Office européen des brevets

(11) **EP 1 965 218 A1**

(12) **EUROPEAN PATENT APPLICATION**

(43) Date of publication:
**03.09.2008 Bulletin 2008/36**

(51) Int Cl.:
*G01R 31/02* (2006.01)     *G01R 27/04* (2006.01)

(21) Application number: **07103214.8**

(22) Date of filing: **28.02.2007**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(71) Applicant: **SAAB AB**
**581 88 Linköping (SE)**

(72) Inventor: **Finander, Per**
**35234, VÄXJÖ (SE)**

(74) Representative: **Herbjörnsen, Rut**
**Albihns AB**
**P.O. Box 5581**
**114 85 Stockholm (SE)**

(54) **Device for testing of cables**

(57)     The invention relates to a plug device (16,16') for use in testing of conductors in a cable (14,14'), said plug device comprising one or more relay cards having an integrated controller and a power source, wherein the relays on said one or more relay cards form one or more matrixes for relay of measurement signals Force and for relay of sensing signals Sense, said integrated controller/-s being controllable to connect and disconnect conductors coupled to the plug and to open or close relays in the matrixes such as to provide for different types of measurements. The invention further relates to a cable testing device for use with one or more plugs according to any of the claims 1 to 5, said testing device (10) comprises two or more relay cards in the cable testing device, a communication/controlling means for communication with one or more plugs, each relay card comprising a matrix for ForceX and SenseX signals, wherein X=A or B, said A and B signals originate from separate relay cards, said relay cards further adapted to be connected to a cable under test and to one of the plug relay matrixes of the one or more plugs. The invention further relates to a method for testing conductors in a cable (14') wherein both ends of the cable (14, 14') cannot be connected directly to a cable testing device (10), wherein the cable testing device is coupled to one end of the cable under test, said cable testing device having two or more relay cards in the cable testing device (10), a communication/controlling means for communication with one or more plugs, each relay card comprising a matrix for ForceX and SenseX signals, wherein X=A or B, said A and B signals originate from separate relay cards, said signals ForceA and SenseA sent to a cable under test to measure at least one of the conductors of the cable and said signals ForceB and SenseB each to one of the plug relay matrixes of the one or more plugs (16,16').

Fig. 2a

Fig. 2b

Description

## FIELD OF THE INVENTION

The present invention generally relates to a device for testing of cables and especially to a smart plug to be used with the same.

## BACKGROUND OF THE INVENTION

Cable testers as such are know in the prior from e.g. US20040066202, US5027074, US4445086, US4277740 and US3986106.

## SUMMARY OF THE INVENTION

The present invention relates to a plug device for use in testing of conductors in a cable according to claim 1, the invention also relates to a cable testing device according to claim 5 to be used with one or more plugs according to any of the claims 1 to 4, the invention further relates to a method according to claim 10 for testing of cables using one or more plug devices and a cable testing device.

Preferred embodiments of the plug device and the cable testing device and the method are shown in the dependent claims.

A cable testing devices usually requires that both ends of a cable to be tested are connected to the testing device. The problem existing, e.g. in larger vehicles, ships, or remote installations, is that it is not possible to use extension cables to reach both ends of the cable.

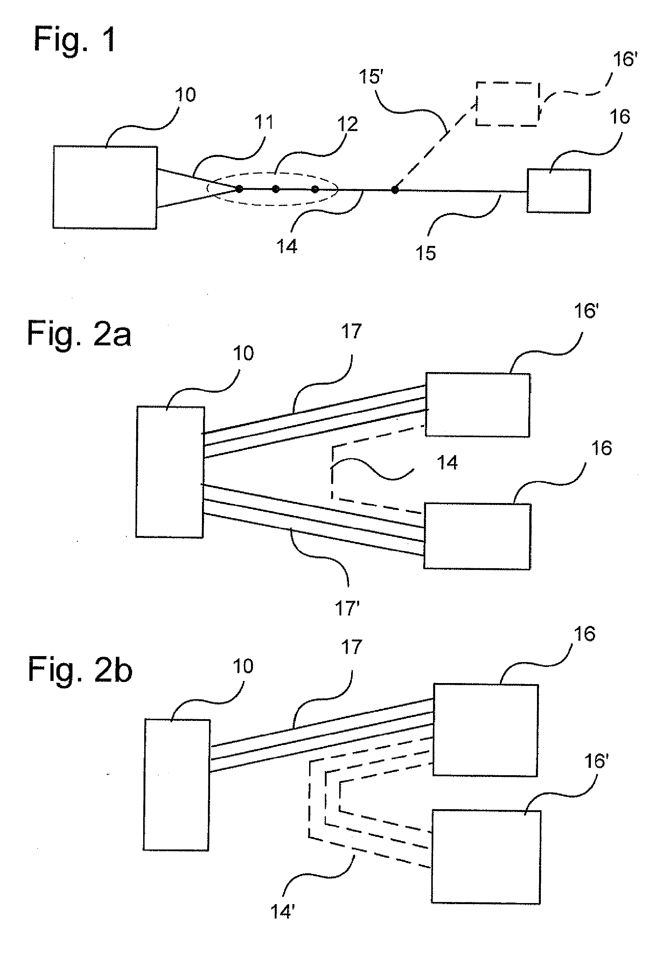

According to the invention the problem may be solved by connecting one end of the cable under test to the cable testing device and a remote device, a plug, attached to the remote end/-s of the cable. This is illustrated in Fig 1.

The invention uses technique from the area of relay cards and the measurement signal may be divided between the conductors of the cable to be tested. The cable testing device according to the invention uses conductors in the tested cable to control the plug(s) and order it/them to connect combinations of different conductors while making measurement, e.g. measuring resistance. During insulation and capacitance tests, the plug(s) are ordered to stay away (to be disconnected from) the cable. When such a measurement is made, the plug disconnects itself/themselves from the cable, waits a predetermined time and thereafter reconnects itself/themselves to listen for new commands. Which conductors in the cable that are connected is registered/controlled by the cable testing device.

By using the conductors in the cable under test as a communication medium is an advantage where a radio transmission or other conductor connections cannot be used due to distance, bulkheads of thick walls.

## BRIEF DESCRIPTION OF THE DRAWINGS

The objects and advantages and features of the present invention will be more readily understood from the following detailed description of the preferred embodiments thereof, when considered in conjunction with the drawings, in which like reference numerals indicate identical structures throughout the several views, and wherein:

Fig. 1     shows a generalised combination of cable tester and plug(s) according to the invention;
Fig. 2a    shows in a generalized form an embodiment of the invention as connected in a first measuring arrangement.
Fig. 2b    shows in a generalized form an embodiment of the invention as connected in a second measuring arrangement.
Fig. 2c    illustrates symbols in the Figures 3 - 13.
Fig. 3     shows an embodiment of a plug according to the invention.
Fig. 4     shows an embodiment according to the invention in which two cable tester relay cards 401, 402 are connected in parallel.

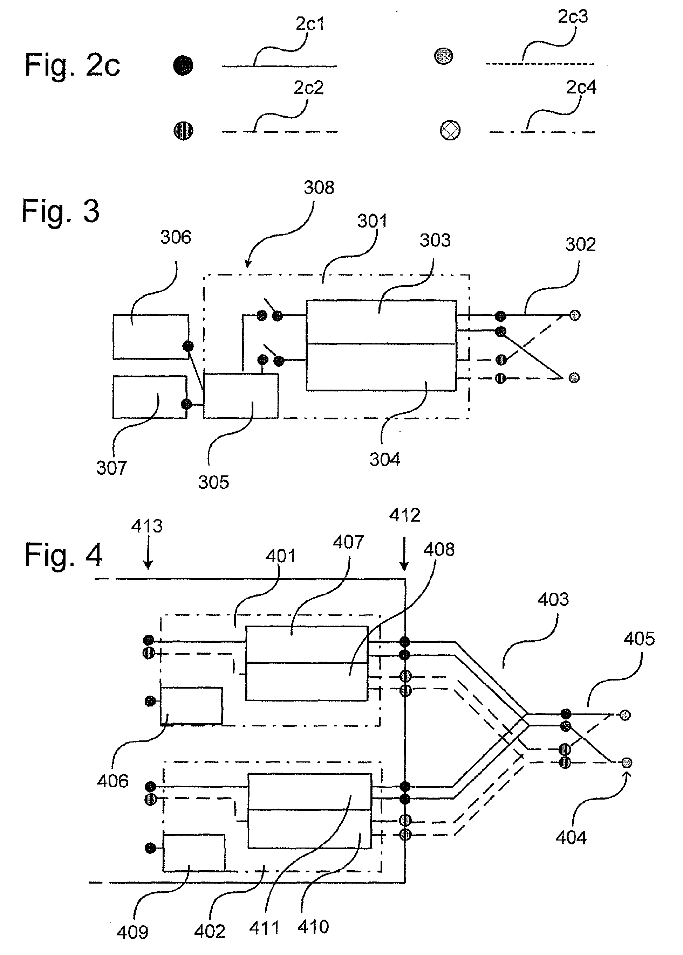

Fig. 4     illustrates an arrangement for a 4-pole measurement according to the invention.

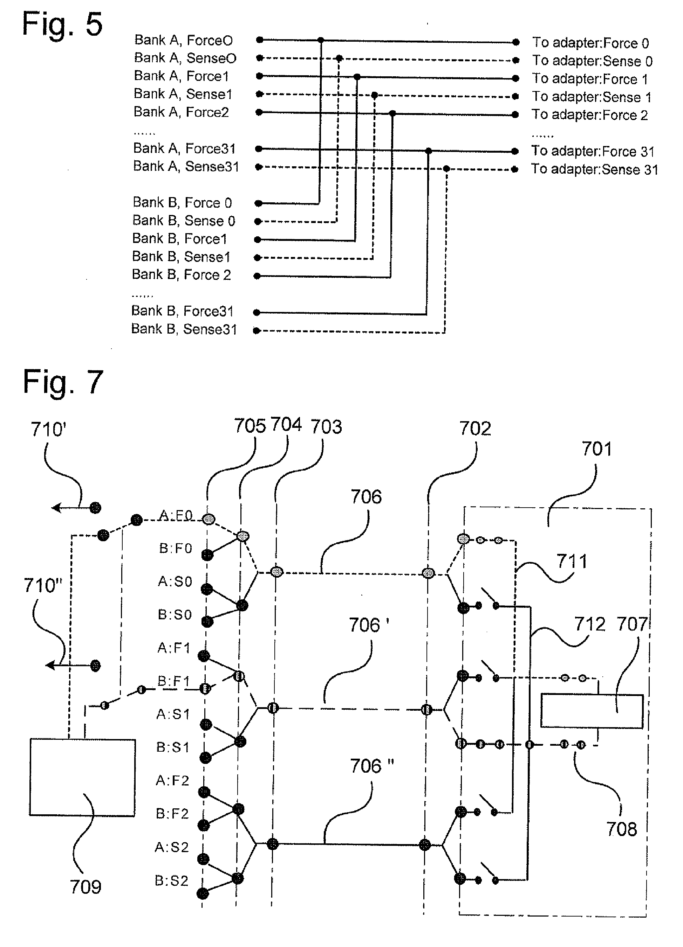

Fig. 5     illustrates the connections in the parallel adapter used according to the invention.

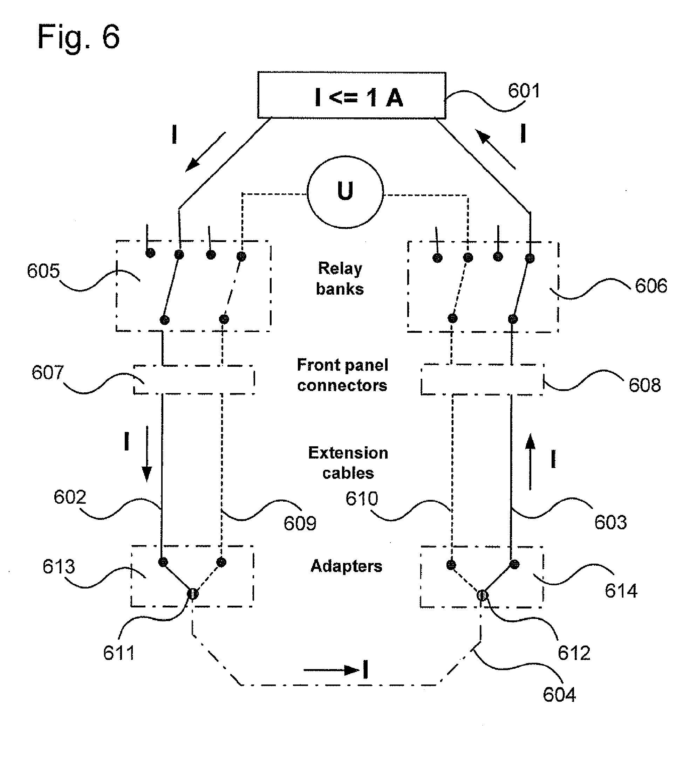

Fig. 6     illustrates the use of Force/Sense-dedicated conductors for resistance measurements.
Fig. 7     illustrates the communication between the plug and the cable tester.

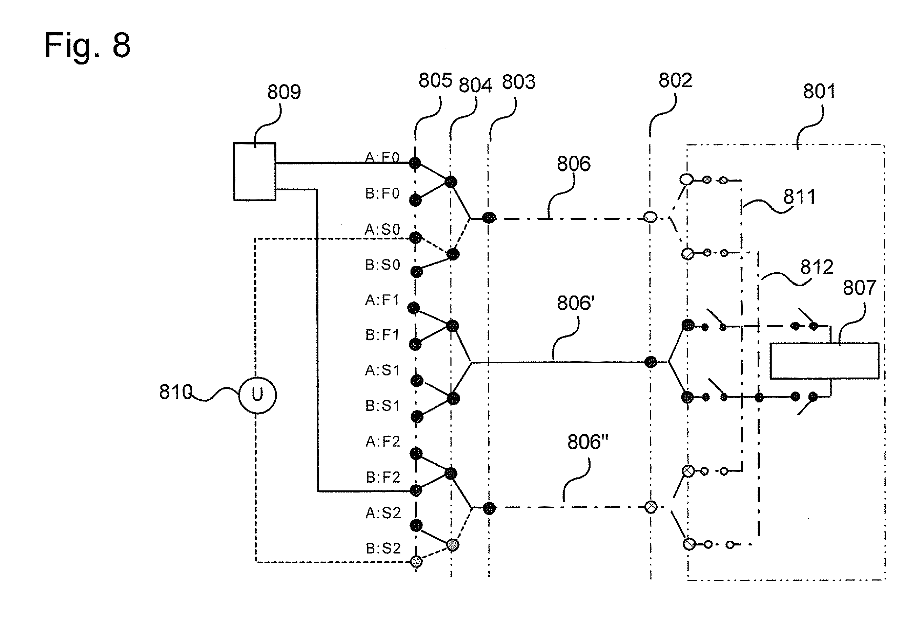

Fig. 8     illustrates resistance test using 2-pole technology.

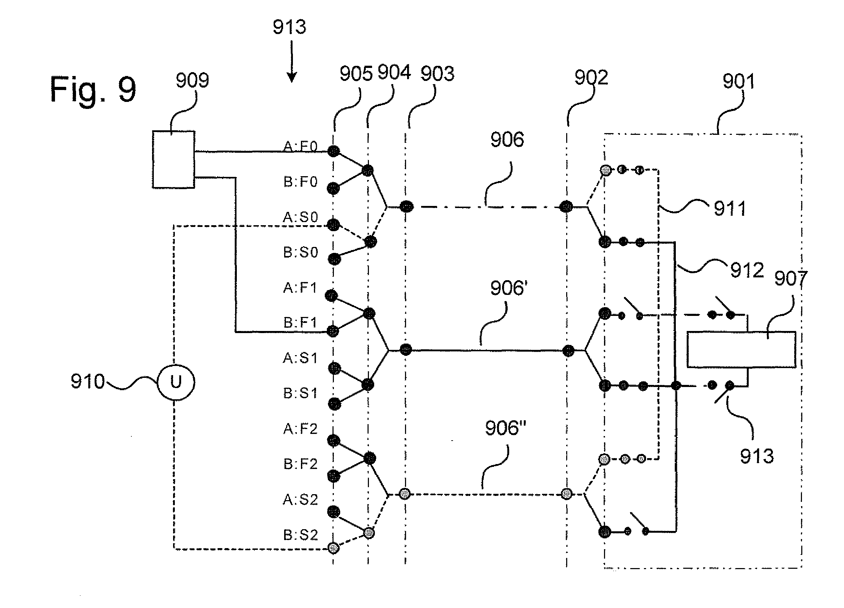

Fig. 9     illustrates resistance test using 4-pole technology.

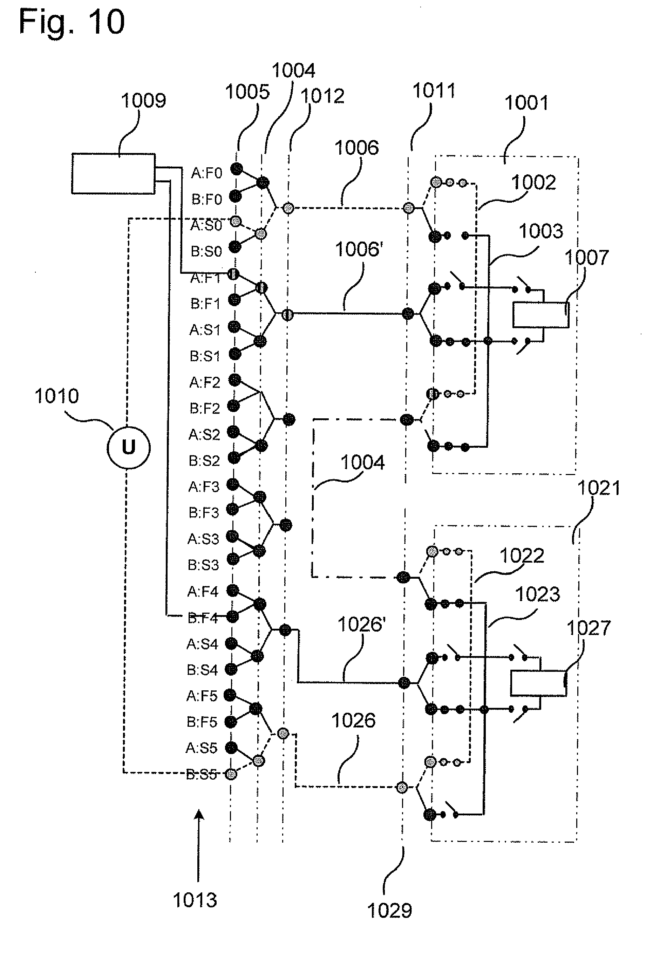

Fig. 10    illustrates the measurement of a conductor coupled to two plugs.

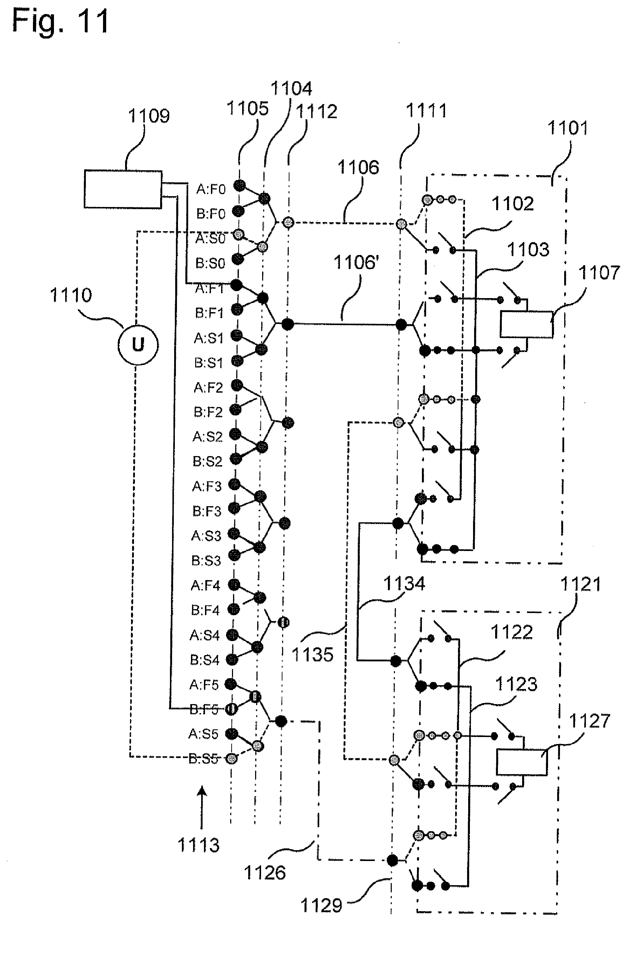

Fig. 11    illustrates a resistance test using 4-pole technology and two plugs

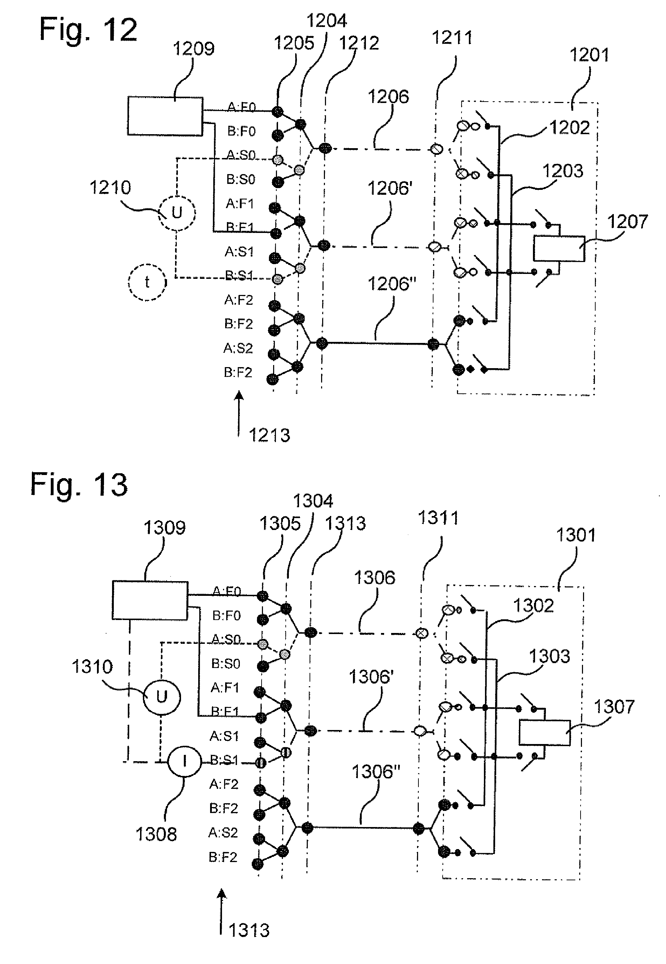

Fig. 12    illustrates a capacitance test
Fig. 13    illustrates an insulation test

## DETAILED DESCRIPTION OF THE PREFERRED EMBODIMENTS OF THE INVENTION

With reference to Figure 1, it illustrates an exemplary setup of a cable tester and a plug according to the invention. In the figure the cable tester 10 is indicated which is connected by a parallel adapter 11 also shown is an extension cable and an adapter 12, the cable 14 being tested, an adapter 15,15' and a smart plug 16, 16'.

This is further illustrated in Fig. 2a and 2b. In Fig. 2a the cable tester 10 is shown connected to two plugs 16 and 16'. Between the plugs a conductor 14 is shown, which is not connected to the cable tester 10. In Fig 2b the cable tester 10 is only connected to one of the plugs 16 and to that same plug a cable having 3 conductors to be tested is connected. The other end of the cable is connected to a second plug 16'.

In Fig. 2c is shown the combinations used in the following figures for different uses of the conductors indicated as: 2c1 - conductor used for "Force"

2c2 - conductor used for "Sense" or for communication 1

2c3 - conductor used for "Sense" or for communication 2

2c4 - conductor under test

According to the invention the cable tester uses the conductors in the cable being tested to control the smart plug and the cable tester also uses the conductors of the cable being tested in order to connect combinations of different conductors while measuring resistance. During insulation and capacitance tests, when measuring conductors connected directly to the cable tester, the plug is ordered to disconnect itself from the cable. When the plug has been disconnected from the cable it waits a specified time and then reconnects itself to listen for new commands.

To be able to control the plug/-s and make combinations of 4-pole measurements the cable must have at least three working conductors. Assuming communication can be established to the plug/-s two working conductors are enough to use with 2-pole measurements.

An embodiment of a plug according to the invention is shown in Fig. 3, wherein a plug relay card 301 is shown connected to an adapter 302 for connection of the cable to be measured (not shown). The plug exhibits matrix 303 and 304 for Force/Sense signals. The matrixes 303 and 304 are each coupled to a communication/controller unit 305 and this unit is then coupled to status indicators 306 and a power source 307. Each Matrix has 32 relays in this embodiment of which only two are shown in Fig. 3. The invention is however not dependent on the number 32 the important provision is that the number of force and sense relays should be equal. The plug may be powered by e.g. a built in rechargeable NiMH battery or an external power source.

In order to obtain the same accuracy in the measurements as if the two ends of a cable are coupled to the cable tester directly via a 4-pole measurement when one or more plug/-s are used all four measurement signals must be sent to the or those conductor/-s in the cable which is/are being tested and which are connected to the cable tester. This is illustrated e.g. in Fig. 10 in the measurement of conductor 1004.

In one embodiment of the relay card set up in the cable tester according to the invention schematically illustrated in Fig. 4 showing one relay card in Bank A and one relay card in bank B.

Via an adapter 403, which connects in parallel a relay card 401 from Bank A and one relay card from Bank B 402 "Force A"/"Sense A" and "Force B"/"Sense B", respectively may be conducted via a connector 404 to two conductors in the cable to be tested and be used in controlling the plug. The connector 404 represents a 4-pole measurement point in a connector to the cable under test. The plug may be remotely controlled as there are two separate conductors to communicate on the same connector. In order to be able to measure a conductor using a four-pole measurement there must however be a third working conductor in the cable.

In Fig. 4 is shown an embodiment according to the invention in which two relay cards 401, 402 are connected in parallel using a parallel adapter 403 for connecting to the adapter 405 and the connector 404 used for connecting to the cable to be tested. Relay card 401 comprises a communication/controller unit 406, a matrix for Force A 407, and a matrix for Sense A 408. Relay card 402 comprises a communication/controller unit 409, a matrix for Force B 411, and a matrix for Sense B 410. The front panel of the cable tester is indicated at 412 and the connections to the internal electronics of the cable tester are indicated at 413. At 404 a 4-pole measurement point is indicated.

In Fig 4 actually each matrix of a total of four has 32 relays of which only two outputs from each are shown.

Cables having up to 32 conductors may be tested if the plug has one relay card, 64 conductors require two relay cards in the plug etc, according to the present design.

The parallel adapter used according to the invention is illustrated in Fig 5. The figure is deemed to be self-explanatory. "Force"/"Sense" are two expressions used when performing four-pole measurements. To illustrate this it is shown in Fig. 6 how a resistance measurement may be performed using a 4-pole measurement.

In Fig. 6 is shown how a high known current being sent via the "Force"-conductors 602, 603 (shown as straight lines) through a conductor 604 under test using a constant current generator 601.

The "Force" conductors comprise the conduction route from the constant current generator 601 to the connection point 611 in the adapter 613, via the conductor 602, for connection of the cable to be measured and from the connection point 612 in the adapter 614, via the conductor 603, to the constant current generator 601. The signals are sent via the relay card 605 and back through the relay card 606, also via the front panel connectors 607, 608, extension cables and adapters via the object to be measured. The "Sense" conductors are indicated as dotted lines.

All conductors, relays and connectors exhibit resistance and the impact of that should be avoided in the resistance measurement. The solution according to the invention is to use the dedicated "sense"-conductors 609, 610 (shown as dotted lines), comprising the conduction route from the constant current generator 601 via the conductor 609 to the connection point 611 in the adapter 613 for connection of the cable to be measured and from the connection point 612 in the adapter 614 via the conductor 610 to the constant current generator 601. The voltmeter U is coupled between the conductors 609, 610 connection points in the relay bank A 605 and the relay bank B 606. As the voltmeter has a very high resistance only a small fraction passes through the same. Almost all current passes through the object being measured.

The "Force" and "Sense" conductors are thus connected to the connection point 611 and 612, respectively, for connection to the measurement object 604. The resistance can now easily be calculated as U/I as the voltage over the object and the current through the object are known. The length of the extension cables and the inner resistance of the test device do not influence the measurement.

In an embodiment according to the invention the measurement described in connection with Fig. 6 may be performed using a cable having at least three conductors wherein one of the conductors will be test and the two others will be used for "Force" and "Sense" respectively.

In order to use the cable tester and the plug communication must be established between the two. This is done in two steps.

Before the cable tester is connected, the plug is connected to the cable to be tested and powered on. The plug makes a short circuit test to see if any conductors in the cable are connected to each other, e.g. short circuited. These conductors are excluded when the plug waits for cable tester to establish communication. When the test is finished, the plug controller initialises the relay card(s) and start listening for command/-s from cable tester (listening mode). Odd relays form one communication line and even relays are the other communication line. If too many conductors are short circuited, the plug lights up a red LED (or the equivalent) indicating that communication cannot be established.

The cable tester is connected to the cable to test. The software in cable tester connects the controller to the cable under test and starts to scan using its relay cards to find the plug. When the plug replies, cable tester tells the plug which conductors to use for communication. The plug starts listening on these conductors and cable tester checks the communication once again. If the plug doesn't get an answer from cable tester on the selected cables it timeouts and returns to listen on all conductors to get a new pair of conductors to communicate on. If the communication test is successful, the communication channel has been established and it's possible to begin sending commands to the plug.

The serial communication is e.g. made in half duplex, 9600 baud.

When the plug is started, only the basic commands needed to establish communication are accepted. Once the communication conductors has been defined and verified, the plug accepts all defined commands.

Each plug has its own unique address to be used in the communication with the controller of the cable tester, which is included in all commands to the plug. The controller in the cable tester communicates with one plug at a time. Battery level and status information are sent back to cable tester from the plug. All cable tester commands are acknowledged from the plug before any action.

With reference to Fig. 7 an illustration is shown of the communication set up. To the left in the figure the communication controller 709 on the first relay card in the cable tester is shown. Indicated also are the connection points 710' and 710" for connection to the measurement electronics in the cable tester. The figure only shows the first 3 pairs of relay in the plug and the three first relays in each bank in the cable tester (A:F0, B:F0, A:S0,..... A:S2, B:S2). Parallel adapters according to Fig. 5 are indicated between the dot-dashed lines 705 and 704. Adapters for connection to the cable under test are indicated between the dot-dashed lines 704 and 703 and connected to these are conductors 706, 706', and 706". The other end of the conductors 706,706', and 706" are connected to adapters indicated between the dot-dashed line 702 and the plug 701.

In the plug, the "Safety relay" 708 is closed to connect the plug controller to the communication conductors in the cable under test. In the figure is only shown the first 3 pairs of relays in the plug and first 3 pairs of relays in each bank in cable tester. Indicated is also Relay Matrix 1 711 and Relay Matrix 2 712

During communication with the plug, the cable tester measurement electronics are disconnected from the relay cards (ForceA, A:F0..., ForceB, B:F0.., SenseA, A:S0... and SenseB, B:S0...) and the plug communication controller in the first relay card in the cable tester is connected instead between the Force signals. The selected communication conductors are connected via the relay cards. All relays and the communication controller are controlled by the CPU and internal software in the cable tester.

In Fig. 8 is shown the performance of a resistance test using 2-pole technology. With reference to Fig. 8 an illustration is shown of the measurement set up. The current generator 809 in the measurement electronics in the cable tester is shown. The figure only shows the first 3 pairs of relay in the plug and the three first relays in each bank in the cable tester (A:F0, B:F0, A:S0, ..... A:S2, B:S2). Parallel adapters according to Fig. 5 are indicated between the dot-dashed lines 805 and 804. Adapters for connection to the cable under test are indicated between the dot-dashed lines 804 and 803 and connected to these are conductors 806, 806', and 806". The other end of the conductors 806, 806', and 806" are connected to adapters indicated between the dot-dashed line 802 and the plug 801.

In the figure is only shown the first 3 pairs of relays in the plug and first 3 pairs of relays in each bank in cable tester. Indicated is also Relay Matrix 1 811 and Relay Matrix 2 812

The plug is ordered from the cable tester to connect two conductors at a time and the resistance is measured by cable tester. Three measurements are required to be able to calculate the resistance of the three conductors in the example in figure 8. The conductors are indicated as follows conductor 1 806, conductor 2 806', and conductor 3 806". Using four parallel adapters and four relay cards in the plug, cables with up to 128 leads can be tested using this method.

The conductors are measured in groups of three:

- Conductors 1 ($R_1$) and 2 ($R_2$) are measured. Result = $R_{12}$

- Conductors 1 ($R_1$ and 3 ($R_3$) are measured. Result = $R_{13}$

- Conductors 2 ($R_2$) and 3 ($R_3$) are measured. Result = $R_{23}$

The individual resistances can be calculated by the formulas:

$$R_1 = (R_{12} + R_{13} - R_{23}) / 2$$

$$R_2 = (R_{12} + R_{23} - R_{13}) / 2$$

$$R_3 = (R_{23} + R_{13} - R_{12}) / 2$$

The calculated values will include the resistances of the adapter, conductors and relays in the plug.

In Fig. 9 is shown the performance of a resistance test using 4-pole technology. With reference to Fig. 9 an illustration is shown of the measurement set up. To the left in the drawing is shown a current generator 909 and a voltmeter 910 <u>in the measurement electronics of the cable tester</u>. The figure only shows the first 3 pairs of relay in the plug and the three first relays in each bank in the cable tester (A:F0, B:F0, A:S0, ..... A:S2, B:S2). Parallel adapters according to Fig. 5 are indicated between the dot-dashed lines 905 and 904. Adapters for connection to the cable under test are indicated between the dot-dashed lines 904 and 903 and connected to these are conductors 906, 906', and 906". The other end of the conductors 906, 906', and 906" are connected to adapters indicated between the dot-dashed line 902 and the plug 901.

In the plug 901, the "Safety relay" 913 is open in order to disconnect the plug controller 907 from the conductors 906, 906' and 906" in the cable under test. In the figure is only shown the first 3 pairs of relays in the plug 901 and first 3 pairs of relays in each bank in the cable tester. Indicated is also Relay Matrix 1 911 and Relay Matrix 2 912. A safety relay 913 for disconnecting the plug controller 907 is also shown.

In the figure is shown an example of a 4-pole resistance test on a conductor between the cable tester and a plug. The conductor tested in this figure is indicated as conductor 906. The relay cards in Bank A indicated at 913 connects ForceA and SenseA to one end of the conductor via the parallel adapters, situated between 904-905, and standard adapters, situated between 903 to 904 and force relay 0 and sense relay 0.

ForceB and SenseB is shown routed to the plug 901: ForceB via Bank B:F1 using the conductor indicated as 906' and SenseB via Bank B:S2, i.e. relay 1 in the relay matrix Force for Bank B and relay 2 in the relay matrix Sense in Bank B. using the conductor indicated as 906" in the cable under test.

The relays in the plug thus connect ForceB, via Matrix 1 911 and SenseB, via Matrix 2 912 to the other end of the conductor under test and form a 4-pole measurement point in the adapter indicated at 902 connecting the conductor under test and the plug. During the measurement, the controller 907 in the plug 901 disconnects itself from the cable under test.

Normally the software in cable tester uses the two communication conductors defined for the plug to route the test (Force) and measurement (Sense) signals but if one of these conductors are to be measured, a third working conductor between the plug and the cable tester is needed. The software tries to locate a third conductor during the communication setup process and use this conductor if necessary during the measurements.

In Fig. 10 the measurement of a conductor using a 4-pole resistance test of a cable having three connectors is illustrated. One connector is connected to the cable tester and the two other to two different plugs. The measurement is made on a conductor which isn't connected directly to the cable tester; the conductor is connected between the two plugs via two adapters 1011, 1029. The cable tester routes the measurement signals using four different conductors in the cable under test to the plugs. With this method, more complex cables can be tested without moving around the cable tester between the connectors.

In the figure is shown the conductor 1004 being measured using 4-pole technology.

To the left in the figure is shown the banks A: F0 ...B:S5 indicated at 1013, connected to the parallel adapters shown between dot-dashed line 1004 and 1005 and to the <u>adapter</u> shown between dot-dashed lines 1004 and 1012 which is situated in the cable tester.

To the right in the figure two plugs 1001 and 1021, each having a controller 1007, and 1027, respectively are shown. In plug 1001 Matrix 1002 is indicated as coupled to SenseA and Matrix 1003 as coupled to ForceA. In plug 1021 Matrix 1022 is indicated as coupled to SenseB and Matrix 1023 as coupled to ForceB. The two adaptors between cabel under test and the plugs are shown between dot-dashed line 1011/plug1001 and dot-dashed line 101/plug1021.

A current generator 1009 is coupled to conductor 1006' ("ForceA" via Bank A:F1) the other end of which is coupled to matrix 1003 and from there coupled to one end of the conductor to be measured 1004. The other end of the conductor 1004 is coupled to matrix 1023 in the second plug. The current generator is also coupled to conductor 1026' ("ForceB" via Bank B:F4) which in turn is coupled to matrix 1023.

A voltmeter 1010 is coupled between conductors 1006 ("SenseA" via Bank A:S0) and 1026 ("SenseB" via Bank B:S5) and the conductors 1006 and 1026 are coupled via matrix 1002 and 1022 respectively to the conductor 1004 being measured.

In Fig. 11 is shown how a 4-pole resistance test of a cable having five conductors may be performed. One conductor 1126 (under test) is coupled to the cable tester and the other two 1135, 1134 to two different plugs 1101, 1121. Because too few conductors are available between the cable tester and the second plug 1121 the measurement and control signals are routed through the first plug 1101.

To the left in the figure is shown the banks A: F0 ...B:S5 indicated at 1113, connected to the parallel adapters shown between dot-dashed line 1104 and 1105 and to the adapter shown between dot-dashed lines 1104 and 1112.

To the right in the figure two plugs 1101 and 1121, each having a controller 1107, and 1127, respectively are shown. In plug 1101 Matrix 1102 is indicated as coupled to SenseA and Matrix 1103 as coupled to ForceA. In plug 1121 Matrix 1122 is indicated as coupled to SenseA via Matrix 1122 and Matrix 1123 as coupled to ForceA. Adaptors for the plugs 1101 and 1121 are shown on the dot-dashed lines 1011, and 1029, respectively. Conductors 1134 and 1135, respectively connect Matrix 1 and Matrix 2 of the respective plugs.

A current generator 1109 is coupled to conductor 1106' ("ForceA" via Bank A:F1) the other end of which is coupled to matrix 1103 and from there coupled to one end of the conductor to be measured 1104. The other end of the conductor 1104 is coupled to matrix 1123 in the second plug. The current generator is also coupled via Bank B5 to the conductor 1126 being measured.

A voltmeter 1110 is coupled between conductors 1106 ("SenseA" via Bank B:S0) and 1126 ("SenseB" via Bank B:S5) and the conductors 1106 and 1126 are coupled via matrix 1102 and 1122 respectively to the conductor 1104 being measured.

In Fig. 12 is shown the set-up for a capacitance test and the in the figure is illustrated measurement of the capacitance between the conductors 1206 and 1206', respectively. The plug 1201 is ordered to be disconnected during the measurement. The time t for charge is measured. The results from the measurements will of course include the capacitance in the adapters and relays in the plug.

In the figure is shown the banks A:F0 .. A:F2 and B:F0 .. B:F2 indicated at 1213, connected to the parallel adapters shown between dot-dashed line 1204 and 1205 and to adapters shown between dot-dashed lines 1244 and 1212 which are situated in the cable tester. All relays in the plug 1201 are shown as open. A controller 1207 is shown in the plug.

A current generator 1209 is coupled via A:F0 to the conductor 1206 and via B:F1 to the conductor 1206' and a voltmeter 1210 is coupled via A:S0 to the conductor 1206 and via B:S 1 to the conductor 1206'. The conductor 1206" is no part of this measurement. Connectors for the plug 1201 is shown on the dot-dashed line 1211.

In Fig. 13 is shown the set-up for an insulation test and the in the figure is illustrated measurement of the insulation between the conductors 1306 and 1306', respectively.

In the figure is shown the banks A:F0 ...BS2 indicated at 1313, connected to the parallel adapters shown between dot-dashed line 1304 and 1305 and to adapters shown between dot-dashed lines 1304 and 1312 which are situated in the cable tester. All relays in the plug 1301 are shown as open. A controller 1307 is shown in the plug.

A high voltage generator 1309 is coupled via A: F0 to the conductor 1306 and via B:S 1 to the conductor 1306' and a voltmeter 1310 is coupled via A:S0 to the conductor 1306 and via B:S1 to the conductor 1306'. The conductor 1306" is no part of this measurement. An ammeter 1308 is shown coupled in series with the voltmeter 1310 and the conductor 1306. Connector for the plug 1301 is shown on the dot-dashed line 1311.

The plug system according to the invention comprises as shown at least two parts:

1. A controller in the cable tester which uses one or more relay cards to communicate with the plug.
2. The plug with one or more relay cards, a controller and a power source.

The controller in the cable tester works as a slave device and is controlled by a CPU. The controller in the plug works as master in order to control the relay cards.

Further as can be understood from the description the cable under test is the tool used in performing the testing.

Although the present invention has been described in connection with preferred embodiments thereof, it will be appreciated by those skilled in the art that additions, deletions, modifications and substitutions not specifically described may be made without departing from the spirit and scope of the invention as defined in the appended claims.

**Claims**

1. A plug device for use in testing of conductors in a cable, **characterized in that** it comprises one or more relay cards (16,16') having an integrated controller and a power source, wherein the relays on said one or more relay cards form one or more matrixes for relay of measurement signals Force and for relay of sensing signals Sense, said integrated controller/-s being controllable to connect and disconnect conductors coupled to the plug and to open or close relays in the matrixes such as to provide for different types of measurements.

2. A plug device according to claim 1, **characterized in that** it comprises at least two matrixes provided on one or two relay cards.

3. Plug device according to any of the claims 1 or 2, said device having means for receiving communication from a cable testing device and wherein said plug exhibits a unique address for communication from the cable testing device.

4. A plug device according to claim 3 **characterized in that** the means for receiving communication from the cable testing device is the cable being tested.

5. A cable testing device for use with one or more plugs according to any of the claims 1 to 5, **characterized in that** it comprises two or more relay cards in the cable testing device, a communication/controlling means for communication with one or more plugs, each relay card comprising a matrix for ForceX and SenseX signals, wherein X=A or B, said A and B signals originate from separate relay cards, said relay cards further adapted to be connected to a cable under test and to one of the plug relay matrixes of the one or more plugs.

6. A cable testing device according to claim 5, **characterized in that** ForceA/SenseA signals and ForceB/SenseB signals are routed to two different plugs (1001,1021), whereat the plugs are coupled to each other to form a series arrangement with the conductor to be tested. (Fig 10)

7. A cable testing device according to claim 5, **characterized in that** the at least two plugs are coupled to each other, connecting the relay matrix in the first plug (1101) for ForceA/SenseA signals with the relay matrix in the second plug (1121) for ForceB/SenseB-signals, whereat the conductor to be measured is coupled between plug 2 and the cable testing device. (Fig. 11)

8. A cable testing device according to claim 5, **characterized in that** a cable, comprising at least 3 conductors, to be tested is coupled between the cable tester and a plug (901) whereat the relay cards in Bank A connects ForceA and SenseA to one end of the conductor (906) via parallel adapters and a standard adapter and to the other end to standard adapters connected to the plug (901), ForceB is routed to the plug 901 using a first conductor (906'), SenseB is routed to the plug (901) using a second conductor (906"). (Fig. 9)

9. Method for testing conductors in a cable, wherein both ends of the cable cannot be connected directly to a cable testing device, wherein the cable testing device is coupled to one end of the cable under test, said cable testing device having two or more relay cards in the cable testing device, a communication/controlling means for communication with one or more plugs, each relay card comprising a matrix for ForceX and SenseX signals, wherein X=A or B, said A and B signals originate from separate relay cards, said signals ForceA and SenseA sent to a cable under test to measure at least one of the conductors of the cable and said signals ForceB and SenseB each to one of the plug relay matrixes of the one or more plugs.

10. Method according to claim 9 in which method all communication between the cable testing device and the one or more plugs is made via the cable being tested.

Fig. 1

Fig. 2a

Fig. 2b

Fig. 2c

2c1

2c3

2c2

2c4

Fig. 3

308

306

301

303

302

307

305

304

Fig. 4

413

412

401

407

408

403

405

406

409

402

411

410

404

# Fig. 6

# Fig. 5

| | | |
|---|---|---|
| Bank A, Force0 | | To adapter:Force 0 |
| Bank A, Sense0 | | To adapter:Sense 0 |
| Bank A, Force1 | | To adapter:Force 1 |
| Bank A, Sense1 | | To adapter:Sense 1 |
| Bank A, Force2 | | To adapter:Force 2 |
| ...... | | ...... |
| Bank A, Force31 | | To adapter:Force 31 |
| Bank A, Sense31 | | To adapter:Sense 31 |
| | | |
| Bank B, Force 0 | | |
| Bank B, Sense 0 | | |
| Bank B, Force1 | | |
| Bank B, Sense1 | | |
| Bank B, Force 2 | | |
| ...... | | |
| Bank B, Force31 | | |
| Bank B, Sense31 | | |

# Fig. 7

Fig. 8

EP 1 965 218 A1

13

Fig. 9

# Fig. 10

# Fig. 11

**Fig. 12**

**Fig. 13**

**European Patent Office**

## EUROPEAN SEARCH REPORT

Application Number

EP 07 10 3214

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 228 072 A (INGALSBE DARYL E [US] ET AL) 13 July 1993 (1993-07-13) * column 1, line 6 - column 11, line 25; figures 4,15 * | 1-10 | INV. G01R31/02 G01R27/04 |
| X | US 4 277 740 A (PARKS KENNETH B) 7 July 1981 (1981-07-07) * abstract; figure 1 * | 1,5,9 | |
| X | GB 2 330 421 A (MENTINC ENTERPRISES LIMITED [IE] MENTINC ENTPR LTD [IE]) 21 April 1999 (1999-04-21) * the whole document * | 1-7,9,10 | |
| X | DE 29 23 585 B1 (SIEMENS AG) 17 July 1980 (1980-07-17) * the whole document * | 1 | |
| X | FR 2 749 395 A1 (AEROSPATIALE [FR]) 5 December 1997 (1997-12-05) * abstract; figures 1-5a * | 1,5,9 | TECHNICAL FIELDS SEARCHED (IPC) G01R H04M |

The present search report has been drawn up for all claims

| Place of search | Date of completion of the search | Examiner |
|---|---|---|
| The Hague | 11 July 2007 | Koll, Hermann |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 07 10 3214

This annex lists the patent family members relating to the patent documents cited in the above-mentioned European search report.
The members are as contained in the European Patent Office EDP file on
The European Patent Office is in no way liable for these particulars which are merely given for the purpose of information.

11-07-2007

| Patent document cited in search report | | Publication date | Patent family member(s) | | Publication date |
|---|---|---|---|---|---|
| US 5228072 | A | 13-07-1993 | AU | 2177692 A | 08-01-1993 |
| | | | WO | 9221986 A1 | 10-12-1992 |
| US 4277740 | A | 07-07-1981 | NONE | | |
| GB 2330421 | A | 21-04-1999 | IE | 970737 A2 | 25-03-1998 |
| DE 2923585 | B1 | 17-07-1980 | NONE | | |
| FR 2749395 | A1 | 05-12-1997 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040066202 A
- US 5027074 A
- US 4445086 A
- US 4277740 A
- US 3986106 A